# EUROPÄISCHE PATENTSCHRIFT

(11) **EP 0 407 902 B1**
(45) Veröffentlichungstag und Bekanntmachung des Hinweises auf die Patenterteilung: **14.09.1994**
(21) Anmeldenummer: 90112907.2
(22) Anmeldetag: 06.07.1990
(51) Int. Cl.: H02J 13/00, G01R 21/133

(54) **Anordnung zur Verbrauchsanzeige eines Versorgungsmittels**
Consumption indication device for supply means
Indicateur de consommation pour un produit d'alimentation

(30) Priorität: 11.07.1989 AU 5156/89
(43) Veröffentlichungstag der Anmeldung: 16.01.1991
(73) Patentinhaber: ALCATEL N.V., NL-1077 XX Amsterdam (NL); ALCATEL AUSTRALIA LIMITED, Alexandria, Sydney 2015 (AU)
(72) Erfinder: Stanbury, Evan John, Lakemba 2195, New South Wales (AU); Thomas, Lloyd Stanley, Gordon 2972, New South Wales (AU)
(74) Vertreter: Pohl, Herbert, Dipl.-Ing.

(56) Entgegenhaltungen:
- WO-A-87/03446
- US-A- 4 396 844
- US-A- 4 803 632
- US-A- 4 819 180

## Beschreibung

Die Anmeldung befaßt sich mit der unerlaubten Benutzung von Versorgungseinrichtungen in unbewohnten Häusern, wie der Versorgung mit Elektrizität, Gas oder Wasser. Eine solche Benutzung kann eintreten, wenn ein Haus verkauft wurde oder ein Mieter aus einer Mietwohnung ausgezogen ist. Obwohl die vorgeschlagene Lösung auf die meisten Versorgungseinrichtungen anwendbar ist, wird sie anhand der Elektrizitätsversorgung einer Mietwohnung beschrieben.

Der ausziehende Mieter sollte dem Versorgungsunternehmen von seinem Auszug Kenntnis geben, welches dann das Ablesen des Zählers und die Erstellung der Abschlußrechnung veranlaßt. Wenn danach ein Verbrauch an Elektrizität stattfindet bevor ein neuer Mieter einzieht, dann hat dieser Mieter für die elektrische Energie zu zahlen, die er nicht verbraucht hat.

Eine Möglichkeit, um das zu vermeiden, besteht darin, den Versorgungsanschluß zu entfernen, wenn die Wohnung ge räumt ist und ihn wieder herzustellen, wenn ein neuer Mieter einzieht. Das ist jedoch aufwendig und mit Kosten verbunden, weil es zwei Besuche eines Angestellten des Versorgungsunternehmens erfordert.

In dem älteren australischen Patent Nr. 586716 (WO 87/03446) ist ein Organisationssystem für Versorgungs ein richtungen vorgeschlagen worden, bei dem ein Verbrauchssteuerungszentrum über Telefonleitungen mit den Zählern bei den Verbrauchern verbunden ist, um beispielsweise das An- und Abschalten in bestimmten Tarifzeiten durchzuführen. In einem bevorzugten Ausführungsbeispiel werden die abgelesenen Meßwerte in elektronischen Speichern gespeichert, die von einem Mikroprozessor gesteuert sind.

Mit der erfindungsgemäßen Lösung soll eine Anordnung für die Verhinderung eines nicht erlaubten Verbrauchs von Versorgungsmitteln geschaffen werden, welche einfacher und mit weniger Aufwand verbunden ist.

Diese Lösung besteht aus einer Anordnung zur Verbrauchsanzeige eines Versorgungsmittels in einer Verbraucherwohnung mit Anzeigemitteln zum Feststellen des Verbrauchs eines Versorgungsmittels, einem ersten Speicher zur Speicherung eines Anzeigesignals, welches anzeigt, ob der Verbrauch in der Verbrauch erwohnung erlaubt oder uner laubt ist und einer Anordnung zur Erzeugung eines Signals bei unerlaubtem Verbrauch, welches auf den Anzeigemittel-Ausgang und den Inhalt des Speichers anspricht und ein Mißbrauchsignal erzeugt, welches zu einer zentralen Steuereinheit gesendet wird, wenn der Anzeigemittel-Ausgang eine Versorgungsmittelverbrauch anzeigt und der erste Speicher eine Information enthält, daß der Verbrauch nicht erlaubt ist.

Eine bevorzugte Ausführungsform der Erfindung enthält eine Organisationsanordnung für Versorgungs ein richtungen mit einer zentralen Steuereinheit, die über ein Nachrichtenübertragungsnetz mit den Meßeinrichtungen eines jeden aus einer Vielzahl von Verbrauchern verbunden ist. Jedes Haus eines Teilnehmers enthält ein Antwortgerät, das durch ein über das Nachrichtenübertragungsnetz empfangenes Signal in Gang gesetzt wird und die Meßwerte erfaßt, die zur zentralen Steuereinheit übermittelt werden sollen.

Die Organisationsanordnung enthält elektronische Speicher, um individuell abgelesene Meßwerte einer Meßeinrichtung bei einem Verbraucher zu speichern. Diese Anordnung enthält außerdem Mittel zur Speicherung eines Signals, welches anzeigt, ob ein Verbrauch erlaubt oder nicht erlaubt ist. Sie enthält auch Mittel, um einen Verbrauch anhand der Meßeinrichtung eines Verbrauchers festzustellen (beispielsweise durch Vergleich aufeinanderfolgender abgelesener Meßwerte einer jeden Meßeinrichtung eines Verbrauchers oder durch Impulszählung an den Meßeinrichtungen). Die Anordnung soll auch Mittel zur Auslösung eines Alarms enthalten, welche auf die Erfassungsmittel anspricht und ein Alarmsignal erzeugt, wenn ein nicht erlaubter Verbrauch auftritt.

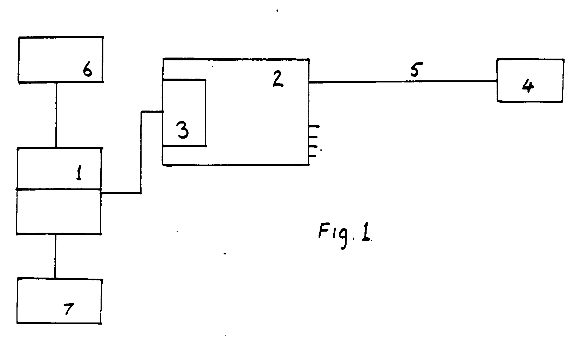

Weitere Einzelheiten der Erfindung sind anhand der bei gefügten Figur beschrieben. In der Figur ist die zentrale Steuereinheit 1 zu erkennen, welche über eine Koppeleinheit 3 an ein Nachrichtenübertragungsnetz 2 angeschlossen ist. Eine Vielzahl von Verbrauchsorganisationseinheiten 4, von denen sich eine in jedem Haus eines Verbrauchers befindet, ist an das Nachrichtenübertragungsnetz 2 angeschlossen, beispielsweise über einzelne Telefonleitungen 5. Von den Verbrauchsorganisationseinheiten 4 ist nur eine gezeigt.

In dieser Anordnung kann der Lieferant des Versorgungsmittels von der zentralen Steuereinheit 1 über das Nachrichtenübertragungsnetz 2 jede Verbrauchsorganisationseinheit 4 abfragen oder die Verbrauchsorganisationseinheit kann jederzeit über das Nachri chtenübertragungsnetz 2 eine Nachricht zur zentralen Steuereinheit 1 schicken. Die Verbrauchsorganisationseinheit 4 liefert Daten, welche den Inhalt eines oder mehrerer Verbrauchsregister anzeigen, und diese Daten werden in einem der zentralen Steuereinheit bei gestellten Speicher gesammelt. Wenn der bisherige Bewohner dem Versorgungsmittellieferanten mitgeteilt hat, daß er aus dem Haus ausgezogen ist, wird diese Information mit dem Terminal 6 in den entsprechenden Signalspeicher in der zentralen Steuereinheit eingegeben, wodurch festgehalten wird, daß jeder weitere Verbrauch von dieser Verbrauchsorganisationseinheit unerlaubt erfolgt. Die Verbrauchsorganisationseinheit kontrolliert den Verbrauch kontinuierlich über ein äußeres oder inneres Meßgerät und die zentrale Steuereinheit kontrolliert regelmäßig die Verbrauchsorganisationseinheit (beispielsweise einmal täglich). Wenn der Verbrauch einen bestimmten Schwellwert übersteigt, dann liefert die zentrale Steuereinheit ein Warnsignal, welches die Warneinheit 7 in Gang setzt. Das Warnsignal kann als eine Anzeige auf einem Bildschirm erscheinen oder als Information ausgedruckt werden. Wenn ein solches Warnsignal festgestellt wird, dann kann der Versorgungsmittellieferant eine Überprüfung (beispielsweise per Telefon) vornehmen, um den neuen Bewohner an seine Verpflichtung zu erinnern. Falls die Überprüfung kein zufiedenstellendes Ergebnis ergibt, kann ein Abschalten der Versorgungseinrichtung veranlaßt werden. Das kann entweder von der zentralen Steuereinheit aus dadurch erfolgen, daß ein von der Verbrauchsorganisationseinheit gesteuertes Relais veranlaßt wird, den Verbrauch er abzutrennen oder es wird ein Mitarbeiter ausgesandt, um den Anschluß zu unterbrechen.

Wenn ein neuer Bewohner den Versorgungsmittel-Lieferanten von seinem Einzug in Kenntnis setzt, kann die Unterbrechung rückgängig gemacht werden. Bei diesem Verfahren ist also lediglich ein Trennen oder Wiederanschließen erforderlich, wenn ein unerlaubter Verbrauch festgestellt wurde.

Bei einer anderen Ausführungsform der Erfindung kann die Erzeugung des Genehmigungssignals und die Vergleichseinrichtung in der Verbrauchsorganisationseinheit angeordnet sein, wobei die Genehmigung zur Abgabe des Genehmigungssignals von der zentralen Steuereinheit gegeben wird und die Verbrauchsorganisationseinheit sendet das Warnsignal über das Nachrichtenübertragungsnetz 2 zur zentralen Steuereinheit. Diese Lösung weist den Vorteil auf, daß der Informationsaustausch an der zentralen Steuereinheit verringert wird, da viele Verbrauchsorganisationseinheiten keine tägliche Verbrauchsmessung benötigen. Sie verringert auch die Zeitspanne, in der ein Versorgungsmitteldiebstahl entdeckt wird, denn die Verbrauchsorganisationseinheit kann beispielsweise ein Warnsignal innerhalb von fünf Minuten abgeben, während die zentrale Steuereinheit in wesentlich größeren Abständen, beispielsweise einmal täglich, überprüft.

Bei einer anderen Ausführungsform wird Alarm ausgelöst, wenn die verbrauchte Energiemenge einen bestimmten Schwellenwert übersteigt. Diese Ausführungsform arbeitet in der Weise, daß ein Zähler dann eingeschaltet wird, wenn das Warnsignal das erste Mal auftritt. Der Zähler wird dann nach jeder Verbrauchseinheit abgefragt und wenn der Schwellenwert überschritten wird, dann wird Alarm ausgelöst. Bei einer anderen Ausführungsform wird der Alarm ausgelöst, wenn der Energieverbrauch einen bestimmten Schwellenwert überschreitet (die Meßeinrichtung selbst oder die Leitungsführung kann eine geringe Menge an Energie verbrauchen). Bei dieser Ausführungsform wird der Zähler bewußt abgeschaltet, um Fehlalarme, die durch Störimpulse oder dgl. ausgelöst werden können, zu verhindern.

Die Anordnung ist vielseitig einsetzbar und kann auch eingesetzt werden, um die Versorgungsmittel lieferung in verschiedenen Kreisläufen in dem Haus eines Verbrauchers zu überwachen. Einige Elektroenergie-Versorgungs unternehmen liefern Energie aus Überproduktion nach einem bestimmten Plan. Wenn Speicher für Heizungsenergie zugelassen sind, dann kann zu bestimmten Zeiten des Tages Energie zu niedrigerem Preis geliefert werden. Beispielsweise wird der Verbrauch von Heißwasser während der Zeit des Niedrigtarifs mit einem Zähler gemessen und der Verbrauch während der Zeit des Normaltarifs mit einem anderen Zähler. Auf die gleiche Weise kann das Netz des Verbrauchers in weitere verschiedene Teilnetze mit eigenen Zählern aufgeteilt werden.

Bei einer weiteren Ausführungsform kann der Verbrauch zu verschiedenen Tageszeiten durch die Verwendung von an bestimmten Tageszeiten wirksamen Registern angezeigt werden. Mit solchen Registern kann ein unerlaubter Verbrauch festgestellt werden, beispielsweise wenn die Bewohner abwesend sind oder wenn die Versorgung mit Überschußenergie abgeschaltet sein sollte. Eine solche Anordnung kann dazu verwendet werden, um einen Einbruchsalarm auszulösen.

## Patentansprüche

1. Anordnung (4) zur Verbrauchsanzei ge eines Versorgungsmittels in einer Verbrauch erwohnung mit Anzeigemitteln zum Feststellen des Verbrauchs eines Versorgungsmittels, gekennzeichnet durch, einen ersten Speicher zur Speicherung eines Anzeigesignals, welches anzeigt, ob der Verbrauch in der Verbrauch erwohnung erlaubt oder uner laubt ist und einer Anordnung zur Erzeugung eines Signals bei unerlaubtem Verbrauch, welches auf den Anzeigemittel-Ausgang und den Inhalt des Speichers anspricht und ein Mißbrauchsignal erzeugt, welches zu einer zentralen Steuereinheit (1) gesendet wird, wenn der Anzeigemittel-Ausgang einen Versorgungsmittelverbrauch anzeigt und der erste Speicher eine Information enthält, daß der Verbrauch nicht erlaubt ist.

2. Anordnung nach Anspruch 1, dadurch gekennzeichnet, daß sie derart ausgestaltet ist, um einen unerlaubten Verbrauch in einer von mehreren Teilnehmerwohnungen festzustellen, mit einer Teilnehmervorrichtung in jeder der Teilnehmerwohnungen, von denen jede Teilnehmervorrichtung über eine Nachrichtenübertragungseinrichtung an eine zentrale Steuereinheit angeschlossen ist und Anzeigemittel sowie eine Nachrichtenübertragungs-Koppeleinheit enthält, welche der Teilnehmervorrichtung die Übertragung von Informationen zur zentralen Steuereinheit gestatten.

3. Anordnung nach Anspruch 2, dadurch gekennzeichnet, daß die Teilnehmervorrichtung die Information des Anzeigemittels zur zentralen Steuereinheit übermittelt.

4. Anordnung nach Anspruch 2, dadurch gekennzeichnet, daß in jeder Teilnehmervorrichtung ein erster Speicher und eine Signalerzeugungsvorrichtung enthalten sind, und die Teilnehmereinrichtung der zentralen Steuereinheit ein Signal übermittelt, wenn ein unerlaubter Verbrauch stattgefunden hat.

5. Anordnung nach Anspruch 4, dadurch gekennzeichnet, daß der Inhalt des ersten Speichers von der zentralen Steuereinheit steuerbar ist.

6. Anordnung nach einem der Ansprüche 2, 3, 4 oder 5, dadurch gekennzeichnet, daß jede Teilnehmereinrichtung Mittel zum Abschalten der Versorgungsmittellieferung enthält.

7. Anordnung nach Anspruch 6, dadurch gekennzeichnet, daß jede Teilnehmereinrichtung Steuermittel enthält, welche auf einen Abschaltbefehl der zentralen Steuereinheit reagieren und Abschaltvorrichtungen in Gang setzen, welche die Versorgungsmittel lieferung zur Teilnehmerwohnung unterbrechen.

8. Anordnung nach Anspruch 7, dadurch gekennzeichnet, daß die Steuermittel auf ein Wiederanschlußsignal der zentralen Steuereinheit reagieren und die Abschaltvorrichtung veranlassen, die Versorgungslieferung zur Teilnehmerwohnung wieder in Gang zu setzen.

9. Anordnung nach Anspruch 8, dadurch gekennzeichnet, daß die Abschaltvorrichtungen von der zentralen Steuereinheit derart gesteuert sind, daß sie in Abhängigkeit von bestimmten Tarifbedingungen arbeiten.

10. Anordnung nach einem der Ansprüche 1 bis 9, dadurch gekennzeichnet, daß die Abschaltvorrichtungen von der zentralen Steuereinheit derart gesteuert sind, daß sie in Abhängigkeit von bestimmten Randbedingungen, wie Tarifen, arbeiten.

11. Verfahren zum Überwachen des Verbrauchs in einer oder mehreren Versorgungseinrichtungen, bei dem der Verbrauch an einer oder jeder Versorgungseinrichtung überwacht wird, dadurch gekennzeichnet daß ein Genehmigungssignal bereitgestellt wird, welches anzeigt, ob der Verbrauch erlaubt oder nicht erlaubt ist, und ein Verbotssignal erzeugt wird, welches zu einer zentralen Steuereinheit (1) gesendet wird, wenn ein unerlaubter Verbrauch stattgefunden hat.

12. Überwachungsverfahren nach Anspruch 11, dadurch gekennzeichnet, daß die Verbrauchsmenge mit einem Verbrauchs-Schwellenwert verglichen wird und ein Verbotssignal erzeugt wird, wenn der erlaubte Verbrauch den Schwellenwert übersteigt.

## Claims

1. A system (4) for monitoring use of a utility at a consumer's premises, the system comprising monitor means to detect use of the utility, characterised in that a first register store an indicator signal indicating whether or not use of the utility at the consumer's premises is authorised, an unauthorised use signal generating means responsive to the monitor output and the contents of the register to generate an unauthorised use signal which will be transmitted to a central control unit (1) when the monitor output indicates use of the utility and the first register contains an indicator signal indicating that use is not authorised.

2. A system as claimed in claim 1 adapted to detect unauthorised use at any of a plurality of subscriber premises, wherein at each of the subscriber's premises a subscriber unit is located, each subscriber unit being connected to a central control unit via communications means, each subscriber unit including a said monitor means and a communication interface to permit the subscriber unit to transmit information to the central control unit.

3. A system as claimed in claim 2 wherein the subscriber unit transmits the output of its monitor means to the central control unit.

4. A system as claimed in claim 2 wherein a said first register and a said signal generating means are included in each subscriber unit and the subscriber unit transmits an unauthroised use signal to the central control unit when unauthorised use has occurred.

5. A system as claimed in claim 4 wherein the contents of the first register are controllable by the central control unit.

6. A system as claimed in any one of claims 2, 3, 4 or 5 including utility cut-off means at each subscriber's premises.

7. A system as claimed in claim 6 wherein each subscriber unit includes control means responsive to a cut-off command received from the central control to cause the cut-off means to cut off the supply of the utility to the consumer's premises.

8. A system as claimed in claim 7 wherein the control means are responsive to a reconnect signal from the central control unit to cause the cut-off means to reconnect the utility supply to the consumer's premises.

9. A system as claimed in claim 8 wherein the cut-off means are controlled by the central control unit to implement an off-peak supply control system.

10. A system as claimed in any one of claims 1 to 9 inclduing memory means storing a signal representing a threshold consumption level and comparator means connected to the output of the monitor means and the memory means, whereby use of the utility is indicated when the use detected by the monitor means exceeds the threshold.

11. A method of monitoring use of one or a plurality of utilities, including the steps of monitoring consumption of the or each utility, characterised in that providing an authorisation signal which indicates whether or not consumptiojn is authorised, and generating an unauthorised use signal which will be transmitted to a central control unit (1) when unauthorised consumption has occurred.

12. A method as claimed in claim 11, including the step of comparing the rate of consumption with a threshold value and generating an unauthorised use signal only if the unauthorised consumption exceeds the threshold value.

## Revendications

1. Dispositif (4) d'indication de la consommation d'un fluide d'un réseau de distribution dans la demeure d'un abonné, comportant des moyens d'affichage pour déterminer la consommation d'un fluide d'un réseau de distribution, caractérisé par une première mémoire pour mémoriser un signal indicateur qui indique si, dans la demeure de l'abonné, la consommation est autorisée ou non, ainsi que par un dispositif qui, en cas de consommation non autorisée, produit un signal qui réagit au signal de sortie du moyen d'affichage et au contenu de la mémoire et un signal de consommation non autorisée, qui est envoyé à une unité centrale de commande (12), lorsque le signal de sortie du moyen d'affichage indique une consommation du fluide du réseau de distribution alors que la première mémoire contient une information selon laquelle cette consommation n'est pas autorisée.

2. Dispositif selon la revendication 1, caractérisé par le fait que, de façon à déterminer une consommation non autorisée dans l'une de plusieurs demeures d'abonné, il est équipé d'un appareil d'abonné dans chacune des demeures d'abonné dont chaque appareil d'abonné est relié, par l'intermédiaire d'un mécanisme de transmission de l'information, à une unité centrale de commande et contient des moyens d'affichage ainsi qu'un organe de couplage de transmission de l'information qui permettent à l'appareil d'abonné la transmission d'informations à l'unité centrale de commande.

3. Dispositif selon la revendication 2, caractérisé par le fait que l'appareil d'abonné transmet à l'unité centrale de commande l'information du moyen d'affichage.

4. Dispositif selon la revendication 2, caractérisé par le fait que dans chaque appareil d'abonné sont contenus une première mémoire et un appareil de production de signaux, et que l'appareil d'abonné transmet à l'unité centrale de commande un signal lorsqu'une consommation non autorisée s'est produite.

5. Dispositif selon la revendication 4, caractérisé par le fait que le contenu de la première mémoire peut être commandé par l'unité centrale de commande.

6. Dispositif selon l'une des revendications 2, 3, 4 ou 5, caractérisé par le fait que chaque appareil d'abonné contient des moyens pour mettre hors circuit la fourniture du fluide du réseau de distribution.

7. Dispositif selon la revendication 6, caractérisé par le fait que chaque appareil d'abonné contient des moyens de manoeuvre qui réagissent à une instruction, provenant de l'unité centrale de commande, de mise hors circuit et mettent en oeuvre des moyens de mise hors circuit qui interrompent la fourniture, à la demeure de l'abonné, du fluide de réseau de distribution.

8. Dispositif selon la revendication 7, caractérisé par le fait que les moyens de manoeuvre réagissent à un signal de reraccordement provenant de l'unité centrale de commande et font en sorte que le moyen de mise en circuit remette en service à nouveau la fourniture, à la demeure de l'abonné, du fluide du réseau de distribution.

9. Dispositif selon la revendication 8, caractérisé par le fait que les moyens de mise hors circuit sont commandés, par l'unité centrale de commande, de façon telle qu'ils travaillent en fonction de conditions tarifaires déterminées.

10. Dispositif selon l'une des revendications 1 à 9, caractérisé par le fait que les moyens de mise hors circuit sont commandés par l'unité centrale de commande de façon telle qu'ils travaillent en fonction de conditions marginales déterminées, comme tarif.

11. Procédé de surveillance de la consommation dans un ou plusieurs appareils pour fluide d'un réseau de distribution, dans le cas duquel la consommation est surveillée sur un, ou sur chaque, appareil pour fluide d'un réseau de distribution, caractérisé par le fait que l'on dispose d'un signal d'autorisation qui indique si la consommation est autorisée ou non, et qu'il est produit un signal d'interdiction, qui est envoyé à une unité centrale de commande (1), si une consommation non autorisée se produit.

12. Procédé de surveillance selon la revendication 11, caractérisé par le fait que la quantité consommée est comparée avec une valeur de seuil de consommation et qu'un signal d'interdiction est produit lorsque la consommation autorisée dépasse la valeur de seuil.
